(19) Europäisches Patentamt
European Patent Office
Office européen des brevets

(11) **EP 1 198 715 B1**

(12) **FASCICULE DE BREVET EUROPEEN**

(45) Date de publication et mention de la délivrance du brevet:
**21.05.2003 Bulletin 2003/21**

(21) Numéro de dépôt: **00956592.0**

(22) Date de dépôt: **02.08.2000**

(51) Int Cl.⁷: $G01R\ 27/26$, $G01R\ 31/40$

(86) Numéro de dépôt international:
**PCT/FR00/02215**

(87) Numéro de publication internationale:
**WO 01/011377 (15.02.2001 Gazette 2001/07)**

(54) **PROCEDE ET DISPOSITIF POUR DETERMINER INDIVIDUELLEMENT L'ETAT DE VIEILLISSEMENT D'UN CONDENSATEUR**

GERÄT UND VERFAHREN ZUR INDIVIDUELLEN BESTIMMUNG DER ALTERUNG EINES KONDENSATORS

METHOD AND DEVICE FOR INDIVIDUALLY DETERMINING THE AGEING CONDITION OF A CAPACITOR

(84) Etats contractants désignés:
**AT BE CH CY DE DK ES FI FR GB GR IE IT LI LU MC NL PT SE**

(30) Priorité: **04.08.1999 FR 9910292**

(43) Date de publication de la demande:
**24.04.2002 Bulletin 2002/17**

(73) Titulaire: **UNIVERSITE CLAUDE BERNARD - LYON 1**
**F-69622 Villeurbanne Cédex (FR)**

(72) Inventeurs:
- **VENET, Pascal**
  **F-01700 Miribel (FR)**
- **PERISSE, Frédéric**
  **F-69003 Lyon (FR)**
- **GRELLET, Guy**
  **F-69700 Montagny (FR)**
- **ROJAT, Gérard**
  **F-69630 Chaponost (FR)**

(74) Mandataire: **Thibault, Jean-Marc**
**Cabinet Beau de Loménie**
**51, Avenue Jean Jaurès**
**B.P. 7073**
**69301 Lyon Cédex 07 (FR)**

(56) Documents cités:
EP-A- 0 652 445          FR-A- 2 768 228
US-A- 4 216 424

- **PATENT ABSTRACTS OF JAPAN vol. 16, no. 80 (P-1318), 26 février 1992 (1992-02-26) & JP 03 269269 A (HITACHI), 29 novembre 1991 (1991-11-29)**

EP 1 198 715 B1

## Description

### DOMAINE TECHNIQUE :

La présente invention concerne le domaine technique du test des condensateurs au sens général, permettant de déterminer l'état de leur fonctionnement ou de leur défaillance.

L'objet de l'invention trouve une application dans le domaine du test des condensateurs pour déterminer leur état de vieillissement.

L'objet de l'invention trouve une autre application pour déterminer l'état de défaillance du ou des condensateurs équipant des systèmes électroniques, de manière à permettre son changement avant sa défaillance complète, en vue d'éviter d'entraver le fonctionnement des systèmes électroniques dans lesquels ce ou ces condensateurs sont installés.

### TECHNIQUE ANTERIEURE :

Les systèmes électroniques font désormais partie de la plupart des équipements ou matériels industriels. Des systèmes électroniques sont ainsi installés dans des équipements médicaux, nucléaires, militaires ou de transports. Il est clair que la défaillance des systèmes électroniques est susceptible d'entraîner un réel danger aussi bien pour les personnes que pour les biens. Dans le même sens, la défaillance du système électronique équipant les machines de fabrication entraîne inévitablement une perte de production.

Un examen approfondi des défaillances des systèmes électroniques a permis de mettre en évidence que la majeure partie des pannes sont imputables aux convertisseurs d'énergie électrique alimentant en tension continue les systèmes électroniques. La défaillance des convertisseurs d'énergie conduit, bien évidemment, à une panne des systèmes qui les équipent avec les conséquences évoquées ci-dessus. Il a été constaté que la plupart des pannes des convertisseurs statiques d'énergie sont dues à une défaillance des condensateurs électrolytiques de filtrage de la tension de sortie ou de la tension d'entrée.

Pour réduire les conséquences liées à de telles pannes, il a été prévu de mettre en oeuvre des convertisseurs statiques comportant une architecture redondante. Il s'avère qu'une telle technique présente un coût élevé en raison de la redondance des composants et imposent une double surveillance en continu pour permettre le remplacement des composants défaillants.

Afin de remédier aux inconvénients de cette technique et en vue de résoudre le problème technique posé, il est connu par le document **FR 2 768 228** de détecter l'ondulation du signal apparaissant aux bornes d'un condensateur et d'analyser la variation de l'ondulation de manière à déceler l'état de défaillance du condensateur dans la mesure où l'ondulation est modifiée lors de l'apparition d'une altération du fonctionnement du condensateur. Par ailleurs, le brevet US **4 216 424** décrit une technique de mesure de la résistance équivalente série d'un condensateur pour déceler un vieillissement ou une dégradation du condensateur.

Les différentes techniques décrites dans l'art antérieur ne donnent pas satisfaction en pratique. En effet, il doit être considéré que les techniques proposées pour détecter l'état de défaillance d'un condensateur présentent un coût relativement important, ne donnent pas une image précise de la résistance équivalente série du condensateur en fonctionnement et ne se trouvent pas adaptées pour connaître la défaillance d'un condensateur lorsque plusieurs condensateurs sont montés en parallèle.

### EXPOSE DE L'INVENTION :

L'objet de l'invention vise donc à remédier aux inconvénients des techniques antérieures en proposant un procédé adapté pour déterminer, selon une technique simple et peu onéreuse, l'état précis de fonctionnement individuel d'un condensateur pris en tant que tel ou monté dans un circuit électrique, tel qu'un convertisseur statique.

Un autre objet de l'invention est d'offrir un procédé permettant de connaître le moment où un condensateur est considéré comme n'assurant plus correctement la fonction à laquelle il est destiné, un tel moment étant connu avant la défaillance complète du condensateur.

Pour atteindre un tel objectif, l'objet de l'invention concerne un procédé pour déterminer l'état de vieillissement d'un condensateur présentant une température, traversé par un courant et aux bornes duquel apparaît une ondulation de tension.

Selon l'invention, le procédé consiste à :

- mesurer, d'une part, l'ondulation de tension apparaissant aux bornes du condensateur et, d'autre part, le courant circulant dans le condensateur,
- déterminer la valeur de la résistance équivalente série de fonctionnement d'un tel condensateur en effectuant le rapport des valeurs de l'ondulation de tension mesurée sur le courant mesuré,
- mesurer la température du condensateur,
- déterminer, pour la température mesurée, et à l'aide d'une loi donnant les variations de la résistance équivalente série en fonction de la température du condensateur, la valeur de la résistance équivalente série, dite théorique, correspondant à un condensateur non défaillant,
- et à comparer la valeur de la résistance équivalente série de fonctionnement avec la valeur de la résistance équivalente série théorique, afin de déterminer l'état de vieillissement du condensateur.

L'objet de l'invention vise également un dispositif pour déterminer l'état de vieillissement d'un condensateur présentant une température, traversé par un courant et aux bornes duquel apparaît une ondulation de tension.

Selon l'invention, le dispositif comporte :

- un moyen de détermination de l'ondulation de tension apparaissant aux bornes du condensateur,
- un moyen de détermination du courant circulant dans le condensateur,
- des moyens de détermination de la valeur de la résistance équivalente série de fonctionnement du condensateur en effectuant le rapport des valeurs de l'ondulation de tension mesuré sur le courant mesuré,
- un moyen de mesure de la température du condensateur,
- des moyens de détermination pour la température mesurée, et à l'aide d'une loi donnant les variations de la résistance équivalente série en fonction de la température, la valeur de la résistance équivalente série, dite théorique, correspondant à un condensateur non défaillant,
- et des moyens de comparaison de la valeur de la résistance équivalente série de fonctionnement avec la valeur de la résistance équivalente série théorique permettant de déterminer l'état de vieillissement du condensateur.

Diverses autres caractéristiques ressortent de la description faite ci-dessous en référence aux dessins annexés qui montrent, à titre d'exemples non limitatifs, des formes de réalisation et de mise en oeuvre de l'objet de l'invention.

**BREVE DESCRIPTION DES DESSINS :**

La **fig. 1** est un schéma-bloc fonctionnel simplifié illustrant un dispositif conforme à l'invention .
La **fig. 2** est une figure illustrant les variations de la résistance équivalente série ESR et de l'impédance Z (en m$\Omega$) en fonction de la fréquence f (Hz).
La **fig. 3** est une figure illustrant les variations de la résistance équivalente série ESR en fonction de la température du boîtier Tb (en °C) d'un condensateur.
La **fig. 4** est un schéma-bloc fonctionnel plus détaillé du dispositif illustré à la **fig. 1.**

**MEILLEURE MANIERE DE REALISER L'INVENTION :**

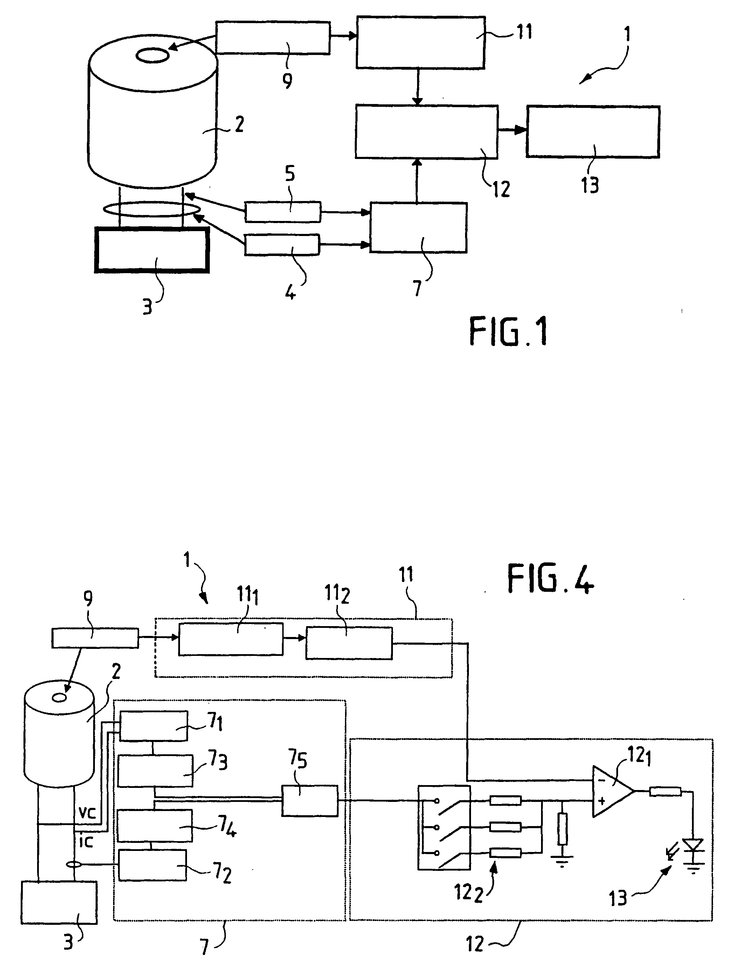

Tel que cela ressort de la **fig. 1,** le dispositif 1 selon l'invention est adapté pour détecter l'état de défaillance ou de vieillissement d'au moins un condensateur **2** monté dans un circuit électrique **3** constitué, dans un exemple préféré de réalisation décrit ci-après, par un convertisseur statique d'énergie électrique d'une tension d'entrée en une tension de sortie continue. Par exemple, le convertisseur d'énergie est une alimentation à découpage dont la tension d'entrée est découpée classiquement à l'aide d'un transistor dont le fonctionnement en commutation, selon une fréquence de découpage **Fc**, est piloté par un circuit de commande.

Dans l'exemple illustré, le ou les condensateurs **2** sont montés sur la sortie du convertisseur statique **3**. Ainsi, le condensateur de filtrage **2** joue le rôle d'une source de tension et peut être du type électrolytique. Aux bornes du condensateur **2** apparaît un signal de tension présentant une ondulation périodique $\Delta$**vc** superposée à une valeur continue. Le dispositif **1**, selon l'invention comporte un moyen **4** de mesure ou de détermination de l'ondulation de tension $\Delta$**vc** apparaissant aux bornes du condensateur **2**. Un tel moyen de mesure **4** peut consister en un prélèvement direct de la tension aux bornes du condensateur ou être réalisé par un capteur de tension spécifique notamment pour des valeurs importantes de tension.

Le dispositif **1** comporte également un moyen **5** de détermination ou de mesure du courant **ic** traversant le condensateur **2** et comportant uniquement une composante haute fréquence. Il est à noter que le moyen de mesure **5** ne doit pas influencer le fonctionnement du condensateur **2**. Aussi, selon une variante préférée de réalisation, le moyen de mesure **5** est constitué par l'intermédiaire d'un transformateur dont le primaire est constitué par un fil de connexion du condensateur **2**, tandis que le secondaire est bobiné sur un tore en ferrite entourant le fil de connexion constituant le primaire.

Le dispositif **1** selon l'invention comporte des moyens **7** adaptés pour déterminer la résistance équivalence série dite de fonctionnement **ESR$_f$** du condensateur **2**. Ces moyens de détermination **7** sont reliés à la sortie des moyens **4** de mesure de la tension apparaissant aux bornes du condensateur et à la sortie des moyens **5** de mesure du courant traversant le condensateur **2**. Il est rappelé que la résistance équivalente série **ESR** d'un condensateur représente toutes les pertes dans le condensateur.

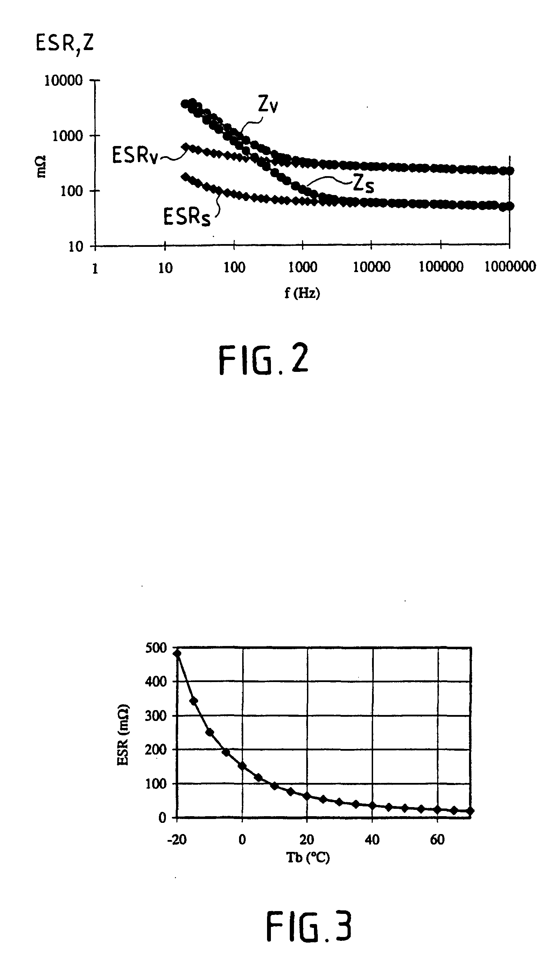

La **fig. 2** représente, pour une température donnée, la variation de la résistance équivalente série **ESR** (**m$\Omega$**) d'un condensateur en fonction de la fréquence **f** (hertz) de la tension apparaissant aux bornes du condensateur. Cette **fig. 2** montre la courbe de la résistance équivalente série **ESR$_s$** pour un condensateur sain et la courbe de la résistance équivalente série **ESR$_v$** pour un condensateur vieilli ou considéré défaillant. Il est à noter que les valeurs de la résistance équivalente série **ESR** augmentent lorsqu'intervient un vieillissement ou une dégradation du condensateur.

Sur la **fig. 2,** il est également représenté la variation, pour une température donnée, de l'impédance totale **Z** du condensateur en fonction de la fréquence **f**. Il est ainsi représenté la courbe de l'impédance **Z$_s$** correspondant à un condensateur sain et la courbe de l'impédance $Z_v$ correspondant à un condensateur vieilli ou défaillant. Il doit être noté que pour des valeurs de hautes fréquences, l'impédance totale $Z$ du condensateur est équivalente à la résistance équivalente série $ESR$. Dans l'exemple illustré, pour une valeur de seuil de fréquence de l'ordre de 10 kHz, l'impédance totale $Z_s$ et la résistance équivalente série $ESR_s$ pour un condensateur sain sont égales, tandis que l'impédance $Z_v$ et la résistance équivalente série $ESR_v$ pour un condensateur vieilli sont égales.

Il est à noter que dans le cas où le condensateur **2** est monté dans un convertisseur statique, il existe généralement une fréquence de commutation supérieure à la valeur de seuil de fréquence (généralement de l'ordre de 10 KHz), de sorte qu'il peut être obtenu l'égalité entre la résistance équivalente série $ESR$ et l'impédance $Z$. Toutefois, dans le cas où un signal de tension à une telle fréquence n'est pas disponible aux bornes du condensateur **2**, il peut être prévu d'injecter aux bornes du condensateur, une ondulation de tension de fréquence supérieure à la valeur de seuil au-dessus de laquelle est obtenue l'égalité entre la résistance équivalente série $ESR$ et l'impédance $Z$.

Ainsi, la détermination de la résistance totale $Z$ du condensateur permet la détermination de la résistance équivalente série $ESR$, pour des valeurs élevées de la fréquence de fonctionnement. Or, la détermination de l'impédance totale $Z$ du condensateur **2** est relativement facile à mener à bien en effectuant le rapport des valeurs de l'ondulation de tension mesurée $\Delta vc$ sur le courant mesuré $ic$. Les moyens **7** permettent ainsi, en effectuant le rapport des valeurs de l'ondulation de tension mesurée sur le courant mesuré, de déterminer l'impédance $Z$ du condensateur, correspondant à la résistance équivalente série de fonctionnement $ESR_f$.

Le dispositif **1** selon l'invention comporte également un moyen **9** de mesure de la température du condensateur **2**. Par exemple, ce moyen de mesure **9** est constitué par une sonde thermique collée sur le boîtier du condensateur **2** permettant de connaître la température du boîtier $Tb$ du condensateur **2**. La température du boîtier peut être assimilée ou déduite de la température au coeur du boîtier du condensateur.

La sortie du moyen **9** de mesure de la température est connectée à des moyens **11** de détermination, pour la température mesurée $Tb$, de la résistance équivalente série, dite théorique $ESR_t$ correspondant à un condensateur sain ou non défaillant. En effet, la résistance équivalente série $ESR$ évolue en fonction de la température boîtier $Tb$, pour un condensateur électrochimique, selon la loi théorique suivante :

$$ESR\ (Tb) = \alpha + \beta \cdot \exp^{-Tb/\gamma},$$

avec $\alpha$, $\beta$, $\gamma$ des constantes à déterminer pour chaque condensateur utilisé.

Un exemple de représentation de cette loi est illustré à la **fig. 3**. Aussi, à partir de cette loi et pour la température mesurée $Tb$, il peut être déduit la résistance équivalente série dite théorique $ESR_t$ correspondant à un condensateur sain ou non défaillant.

La sortie des moyens **11** de détermination de la résistance équivalente série théorique $ESR_t$ et la sortie des moyens **7** de détermination de la résistance équivalente série de fonctionnement $ESR_f$ sont connectées à des moyens **12** de comparaison des deux valeurs de résistances équivalentes séries $ESR_f$ et $ESR_t$ permettant de déterminer l'état de vieillissement du condensateur. Ainsi, si la résistance équivalente série de fonctionnement $ESR_f$ correspond sensiblement à la résistance équivalente série théorique $ESR_t$, il peut être considéré que le condensateur **2** est sain ou non défaillant. Toutefois, si la valeur de la résistance équivalente série de fonctionnement $ESR_f$ présente par rapport à la valeur de la résistance équivalente série théorique $ESR_t$, un écart déterminé correspondant à un seuil donné, il peut être considéré que le condensateur **2** est dans un état défaillant. A titre d'exemple, il peut être choisi comme valeur de seuil pour déterminer l'état de défaillance d'un condensateur, la valeur double de la résistance équivalente série théorique $ESR_t$. Les moyens de comparaison **12** sont adaptés pour être reliés à des moyens **13** assurant l'émission d'un signal d'avertissement, lorsque l'écart entre la résistance équivalente série de fonctionnement $ESR_f$ et la résistance équivalente série théorique $ESR_t$ dépassent la valeur de seuil donnée. Un tel signal d'avertissement peut être lumineux, sonore, ou être transmis à une unité de surveillance.

Le dispositif **1** décrit ci-dessus présente l'avantage de mettre en oeuvre un procédé relativement simple pour connaître l'état de vieillissement d'un condensateur. En effet, le procédé consiste, à un instant déterminé, à mesurer la température du condensateur, le courant traversant le condensateur et la tension appliquée aux bornes du condensateur. A partir des valeurs de tension et de courant, il peut être obtenu la valeur de la résistance équivalente série, dite de fonctionnement $ESR_f$, tandis qu'à partir de la température du condensateur, la valeur de la résistance équivalente série théorique $ESR_t$ correspondant à un condensateur sain peut être déterminée. La différence entre ces deux valeurs de résistance équivalente série permet de savoir si le condensateur satisfait toujours aux critères de fonctionnement choisis. En fonction du seuil d'écart fixé entre les résistances équivalentes séries de fonctionnement $ESR_f$ et théorique $ESR_t$, il est possible de déterminer un état de défaillance préalable à un état de défaillance complet du condensateur. Le condensateur **2** peut ainsi être remplacé avant sa défaillance complète. De plus, un tel procédé peut être mis en oeuvre par l'intermédiaire d'un dispositif réalisé à l'aide de composants de faible coût qui sont simples à mettre en oeuvre. Aussi, il apparaît possible de monter un tel dispositif **1** directement sur le boîtier de chaque condensateur à surveiller ou à tester. Un tel dispositif de surveillance individuelle offre l'avantage de détecter la défaillance d'un condensateur même si plusieurs condensateurs sont montés en parallèle.

La **fig. 4** décrit un exemple de réalisation d'un tel dispositif **1** de détermination de l'état de vieillissement d'un condensateur. Les moyens **7** de détermination de la résistance équivalente série de fonctionnement $ESR_f$ comportent un filtre passe-bande $7_1$ à l'entrée duquel est appliquée la tension **vc** apparaissant aux bornes du condensateur et un filtre basse-bande $7_2$ à l'entrée duquel est appliqué le courant **ic**. Ainsi, les filtres passe-bande $7_1$, $7_2$ permettent, de préférence, de détecter le fondamental d'un courant **ic** circulant dans le condensateur et le fondamental de l'ondulation de tension $\Delta$**vc** apparaissant aux bornes du condensateur. De préférence, la fréquence centrale des filtres passe-bande $7_1$, $7_2$ est asservie à la fréquence de découpage du convertisseur statique **3**. Les sorties des filtres passe-bande $7_1$, $7_2$ sont reliées à des convertisseurs, respectivement $7_3$ pour la tension et $7_4$ pour le courant, délivrant chacun une valeur continue. Les convertisseurs $7_3$, $7_4$ convertissent la valeur efficace vraie respectivement de tension et de courant, en des valeurs continues qui sont des images de l'ondulation de tension $\Delta$**vc** et du courant **ic**. Les sorties des convertisseurs $7_3$, $7_4$ sont connectées à un étage diviseur analogique $7_5$ permettant d'effectuer la division de la valeur efficace de l'ondulation de tension sur la valeur efficace de courant. La sortie de l'étage diviseur $7_5$ délivre ainsi un signal représentatif de la résistance équivalente série de fonctionnement $ESR_f$.

Les moyens de détermination **11** de la résistance équivalente série théorique $ESR_t$ comportent un étage $11_1$ de conditionnement du signal délivré par le moyen **9** de mesure de la température **Tb** du condensateur. Cet étage de conditionnement $11_1$ du signal est relié en sortie à un circuit $11_2$ réalisant le calcul de la fonction exponentielle permettant de déterminer la résistance équivalente série théorique à partir de la température mesurée du boîtier.

La sortie du circuit de calcul $11_2$, ainsi que la sortie de l'étage diviseur $7_5$ sont connectées aux moyens de comparaison **12** constitués, dans l'exemple illustré, par un circuit comparateur $12_1$ constitué d'un amplificateur dont l'une des bornes est reliée à la sortie du circuit de calcul $11_2$, tandis que l'autre borne est connectée à des moyens de seuil $12_2$ du type à interrupteur présentant plusieurs valeurs de seuil de déclenchement. La sortie de l'amplificateur est reliée aux moyens d'avertissement **13** formés, dans l'exemple illustré, par une diode électroluminescente.

L'invention n'est pas limitée aux exemples décrits et représentés, car diverses modifications peuvent y être apportées sans sortir de son cadre.

**Revendications**

1. Procédé pour déterminer l'état de vieillissement d'un condensateur (**2**) présentant une température (**Tb**), traversé par un courant (**ic**) et aux bornes duquel apparaît une ondulation de tension ($\Delta$**vc**), **caractérisé en ce qu'**il consiste à :

   - mesurer, d'une part, l'ondulation de tension ($\Delta$**vc**) apparaissant aux bornes du condensateur (**2**) et, d'autre part, le courant (**ic**) circulant dans le condensateur,
   - déterminer la valeur de la résistance équivalente série de fonctionnement ($ESR_f$) d'un tel condensateur en effectuant le rapport des valeurs de l'ondulation de tension mesurée ($\Delta$**vc**) sur le courant mesuré (**ic**),
   - mesurer la température (**Tb**) du condensateur (**2**),
   - déterminer, pour la température mesurée (**Tb**), et à l'aide d'une loi donnant les variations de la résistance équivalente série (**ESR**) en fonction de la température du condensateur, la valeur de la résistance équivalente série dite théorique ($ESR_t$) correspondant à un condensateur non défaillant,
   - et à comparer la valeur de la résistance équivalente série de fonctionnement ($ESR_f$) avec la valeur de la résistance équivalente série théorique ($ESR_t$), afin de déterminer l'état de vieillissement du condensateur.

2. Procédé selon la revendication 1, **caractérisé en ce qu'**il consiste à déterminer la valeur de la résistance équivalente série de fonctionnement ($ESR_f$) à partir d'une ondulation de tension de fréquence supérieure à une valeur de seuil au-dessus de laquelle est obtenue l'égalité entre la résistance équivalente série et l'impédance du condensateur.

3. Procédé selon la revendication 1 ou 2, **caractérisé en ce qu'**il consiste à détecter le fondamental du courant (**ic**) circulant dans le condensateur et le fondamental de l'ondulation de tension ($\Delta$**vc**) apparaissant aux bornes du condensateur, en vue de déterminer la résistance équivalente série de fonctionnement ($ESR_f$).

4. Procédé selon l'une des revendications 1 à 3, **caractérisé en ce qu'**il consiste à déterminer la valeur efficace de l'ondulation de tension et la valeur efficace de l'ondulation du courant, en vue de déterminer la résistance équivalente série de fonctionnement ($ESR_f$).

5. Procédé selon la revendication 1, **caractérisé en ce qu'**il consiste à émettre un signal d'avertissement correspondant à un état de défaillance du condensateur, lorsque l'écart entre la résistance équivalente série de fonctionnement $(ESR_f)$ et la résistance équivalente série théorique $(ESR_t)$ dépasse une valeur de seuil déterminée.

6.  Dispositif pour déterminer l'état de vieillissement d'un condensateur présentant une température $(Tb)$, traversé par un courant $(ic)$ et aux bornes duquel apparaît une ondulation de tension $(\Delta vc)$, **caractérisé en ce qu'**il comporte :

    -   un moyen **(4)** de détermination de l'ondulation de tension $(\Delta vc)$ apparaissant aux bornes du condensateur,
    -   un moyen **(5)** de détermination du courant $(ic)$ circulant dans le condensateur,
    -   des moyens **(7)** de détermination de la valeur de la résistance équivalente série de fonctionnement $(ESR_f)$ du condensateur en effectuant le rapport des valeurs de l'ondulation de tension mesuré sur le courant mesuré,
    -   un moyen de mesure **(9)** de la température du condensateur **(2)**,
    -   des moyens **(11)** de détermination pour la température $(Tb)$ mesurée, et à l'aide d'une loi donnant les variations de la résistance équivalente série $(ESR)$ en fonction de la température $(Tb)$, la valeur de la résistance équivalente série dite théorique $(ESR_t)$ correspondant à un condensateur non défaillant,
    -   et des moyens **(12)** de comparaison de la valeur de la résistance équivalente série de fonctionnement $(ESR_f)$ avec la valeur de la résistance équivalente série théorique $(ESR_t)$ permettant de déterminer l'état de vieillissement du condensateur.

7.  Dispositif selon la revendication 6, **caractérisé en ce que** les moyens **(7)** de détermination de la résistance équivalente série de fonctionnement $(ESR_f)$ comportent un filtre passe-bande $(7_1)$ pour l'ondulation de tension et un filtre passe-bande $(7_2)$ pour le courant.

8.  Dispositif selon la revendication 7, **caractérisé en ce que** chaque sortie des filtres passe-bande $(7_1, 7_2)$ est reliée à un convertisseur $(7_3, 7_4)$ de la valeur efficace vraie, délivrant chacun une valeur continue, image respectivement de l'ondulation de tension et du courant, la sortie des convertisseurs $(7_3, 7_4)$ étant connectée à un étage diviseur $(7_5)$ des valeurs d'ondulation de la tension sur le courant.

9.  Dispositif selon la revendication 6, **caractérisé en ce que** le moyen **(5)** de détermination de l'ondulation de courant est constitué par un transformateur de courant donnant un image du courant circulant dans le condensateur.

10. Dispositif selon la revendication 6, **caractérisé en ce que** les moyens de comparaison **(12)** sont constitués par un circuit comparateur de la résistance équivalente série de fonctionnement $(ESR_f)$ avec la résistance équivalente série théorique $(ESR_t)$, relié à un circuit d'avertissement **(13)** délivrant un signal d'avertissement, lorsque la différence des valeurs des résistances dépasse un seuil déterminé.

11. Dispositif adapté pour déterminer l'état de vieillissement d'un condensateur connecté à un convertisseur statique selon l'une des revendications 6 à 10, **caractérisé en ce qu'**il comporte des filtres passe-bande $(7_1, 7_2)$ dont la fréquence centrale est asservie à la fréquence de découpage du convertisseur statique.

12. Condensateur **caractérisé en ce qu'**il est équipé d'un dispositif **(1)** conforme à l'une des revendications 6 à 10.

**Claims**

1.  A method of determining the aging state of a capacitor (2) presenting a temperature (Tb), conveying a current (ic), and having voltage ripple ($\Delta vc$) appearing across its terminals, the method being **characterized in that** it consists in:

    · measuring both the voltage ripple ($\Delta vc$) appearing across the terminals of the capacitor (2), and the current (ic) flowing through the capacitor;
    · determining the equivalent series resistance in operation $(ESR_f)$ of such a capacitor by taking the ratio of the measured voltage ripple ($\Delta vc$) divided by the measured current (ic);
    · measuring the temperature (Tb) of the capacitor (2);
    · using a relationship specifying variation in equivalent series resistance (ESR) as a function of capacitor temperature, to determine the value of the theoretical equivalent series resistance $(ESR_t)$ corresponding to a non-faulty capacitor at the measured temperature (Tb); and
    · comparing the equivalent series resistance in operation $(ESR_f)$ with the theoretical equivalent series resistance $(ESR_t)$ in order to determine the state of aging of the capacitor.

2.  A method according to claim 1, **characterized in that** it consists in determining the equivalent series resistance in operation $(ESR_f)$ on the basis of voltage ripple at a frequency above a threshold value above which the equivalent series resistance and the impedance of the capacitor are equal.

3. A method according to claim 1 or claim 2, **characterized in that** it consists in detecting the fundamental of the current (ic) flowing through the capacitor and the fundamental of the voltage ripple ($\Delta$vc) across the terminals of the capacitor, in order to determine the equivalent series resistance in operation ($ESR_f$).

4. A method according to any one of claims 1 to 3, **characterized in that** it consists in determining the rms value of the voltage ripple and the rms value of the current ripple in order to determine the equivalent series resistance in operation ($ESR_f$).

5. A method according to claim 1, **characterized in that** it consists in issuing a warning signal corresponding to a faulty state of the capacitor whenever the difference between the equivalent series resistance in operation ($ESR_f$) and the theoretical equivalent series resistance ($ESR_t$) exceeds a determined threshold value.

6. Apparatus for determining the state of aging of a capacitor presenting a temperature (Tb), conveying a current (ic), and having a voltage ripple ($\Delta$vc) appearing across its terminals, the apparatus being **characterized in that** it comprises:

   · means (4) for determining the voltage ripple ($\Delta$vc) that appears across the terminals of the capacitor;
   · means (5) for determining the current (ic) flowing through the capacitor;
   · means (7) for determining the equivalent series resistance in operation ($ESR_f$) of the capacitor by taking the ratio of the measured voltage ripple divided by the measured current;
   · means (9) for measuring the temperature of the capacitor (2);
   · means (11) for determining the theoretical equivalent series resistance ($ESR_t$) corresponding to a non-faulty capacitor on the basis of the measured temperature (Tb) and a relationship specifying variations in equivalent series resistance (ESR) as a function of temperature (Tb); and
   · means (12) for comparing the equivalent series resistance in operation ($ESR_f$) with the theoretical equivalent series resistance ($ESR_t$), enabling the state of aging of the capacitor to be determined.

7. Apparatus according to claim 6, **characterized in that** the means (7) for determining the equivalent series resistance in operation ($ESR_f$) include a bandpass filter ($7_1$) for the voltage ripple and a bandpass filter ($7_2$) for the current.

8. Apparatus according to claim 7, **characterized in that** the each output from a bandpass filter ($7_1$, $7_2$) is connected to a true rms converter ($7_3$, $7_4$), each delivering a DC value that is the image respectively of the voltage ripple and of the current, the outputs from the converters ($7_3$, $7_4$) being connected to a divider stage ($7_5$) for dividing the voltage ripple value by the current value.

9. Apparatus according to claim 6, **characterized in that** the means (5) for determining the current ripple are constituted by a current transformer giving an image of the current flowing through the capacitor.

10. Apparatus according to claim 6, **characterized in that** the comparator means (12) are constituted by a circuit for comparing the equivalent series resistance in operation ($ESR_f$) with the theoretical equivalent series resistance ($ESR_t$), connected to a warning circuit (13) that delivers a warning signal when the difference between the resistances exceeds a determined threshold.

11. Apparatus according to any one of claims 6 to 10 for determining the aging state of a capacitor connected to a static converter, the apparatus being **characterized in that** it includes bandpass filters ($7_1$, $7_2$) of center frequency servo-controlled to the chopper frequency of the static converter.

12. A capacitor, **characterized in that** it is fitted with apparatus (1) in accordance with any one of claims 6 to 10.

**Patentansprüche**

1. Verfahren zum Bestimmen des Alterungszustandes eines Kondensators (2), der eine Temperatur (Tb) aufweist und von einem Strom (ic) durchflossen wird und an dessen Klemmen eine Spannungswelligkeit ($\Delta$vc) auftritt,
   **dadurch gekennzeichnet, dass** es darin besteht:

   - einerseits die an den Klemmen des Kondensators (2) auftretende Spannungswelligkeit ($\Delta$vc) und andererseits den im Kondensator fließenden Strom (ic) zu messen,
   - den Wert des Betriebs-Ersatzserienwiderstands ($ESR_f$) eines derartigen Kondensators zu bestimmen, indem der Bezug zwischen dem Wert der gemessenen Spannungswelligkeit ($\Delta$vc) und dem Wert des gemessenen Stroms (ic) hergestellt wird,
   - die Temperatur (Tb) des Kondensators (2) zu messen,
   - für die gemessene Temperatur (Tb) mit Hilfe eines Gesetzes, aus dem sich die Veränderungen des Ersatzserienwiderstandes (ESR) in Abhängigkeit der Temperatur des Kondensators ergeben, den Wert des sogenannten theoretischen Ersatzserienwiderstands (ESR$_t$), der einem nicht geschwächten Kondensator entspricht, zu bestimmen,

- und den Wert des Betriebs-Ersatzserienwiderstands (ESR$_f$) mit dem Wert des theoretischen Ersatzserienwiderstands (ESR$_t$) zu vergleichen, um den Alterungszustand des Kondensators zu bestimmen.

2. Verfahren nach Anspruch 1, **dadurch gekennzeichnet, dass** es darin besteht, den Wert des Betriebs-Ersatzserienwiderstands (ESR$_f$) anhand einer Spannungswelligkeit einer Frequenz zu bestimmen, die über einem Grenzwert liegt, oberhalb dem eine Gleichheit zwischen dem Ersatzserienwiderstand und der Impedanz des Kondensators erzielt wird.

3. Verfahren nach Anspruch 1 oder 2, **dadurch gekennzeichnet, dass** es darin besteht, die Grundschwingung des in dem Kondensator fließenden Stroms (ic) und die Grundschwingung der an den Klemmen auftretenden Spannungswelligkeit (∆vc) zu erfassen, um den Betriebs-Ersatzserienwiderstand (ESR$_f$) zu bestimmen.

4. Verfahren nach einem der Ansprüche 1 bis 3, **dadurch gekennzeichnet, dass** es darin besteht, den tatsächlichen Wert der Spannungswelligkeit und den tatsächlichen Wert der Welligkeit des Stroms zu bestimmen, um den Betriebs-Ersatzserienwiderstand (ESR$_f$) zu bestimmen.

5. Verfahren nach Anspruch 1, **dadurch gekennzeichnet, dass** es darin besteht, ein Alarmsignal abzugeben, das einem schwachen Zustand des Kondensators entspricht, wenn die Abweichung zwischen dem Betriebs-Ersatzserienwiderstand (ESR$_f$) und dem theoretischen Ersatzserienwiderstand (ESR$_t$) einen bestimmten Grenzwert übersteigt.

6. Vorrichtung zum Bestimmen des Alterungszustands eines Kondensators, der eine Temperatur (Tb) aufweist, von einem Strom durchflossen wird und an dessen Klemmen eine Spannungswelligkeit (∆vc) auftritt, **dadurch gekennzeichnet, dass** sie umfasst:

- ein Mittel (4) zur Bestimmung der an den Klemmen des Kondensators auftretenden Spannungswelligkeit (∆vc),
- ein Mittel (5) zum Bestimmen des in dem Kondensator fließenden Stroms (ic),
- Mittel (7) zur Bestimmung des Wertes des Betriebs-Ersatzserienwiderstands (ESR$_f$) des Kondensators durch Herstellen des Bezugs zwischen dem Wert der gemessenen Spannungswelligkeit und dem Wert des gemessenen Stroms,

- ein Mittel zum Messen (9) der Temperatur des Kondensators (2),
- Mittel (11) zur Bestimmung, für die gemessene Temperatur (Tb) und mit Hilfe eines Gesetzes, aus dem sich die Veränderungen des Ersatzserienwiderstandes (ESR) in Abhängigkeit der Temperatur (Tb) ergeben, des Wertes des so genannten theoretischen Ersatzserienwiderstands (ESR$_t$), der einem nicht geschwächten Kondensator entspricht,
- und Mittel (12) zum Vergleichen des Wertes des Betriebs-Ersatzserienwiderstands (ESR$_f$) mit dem Wert des theoretischen Ersatzserienwiderstands (ESR$_t$), die das Bestimmen des Alterungszustandes des Kondensators erlauben.

7. Vorrichtung nach Anspruch 6, **dadurch gekennzeichnet, dass** die Mittel (7) zur Bestimmung des Betriebs-Ersatzserienwiderstands (ESR$_f$) einen Bandpassfilter (7$_1$) für die Spannungswelligkeit und einen Bandpassfilter (7$_2$) für den Strom umfassen.

8. Vorrichtung nach Anspruch 7, **dadurch gekennzeichnet, dass** jeder Ausgang der Bandpassfilter (7$_1$, 7$_2$) mit einem Wandler (7$_3$, 7$_4$) des wirklichen Effektivwertes verbunden ist, der jeweils einen kontinuierlichen Wert als Abbild der Spannungswelligkeit bzw. des Stroms liefert, wobei der Ausgang der Wandler (7$_3$, 7$_4$) mit einer Stufe zur Teilung (7$_5$) der Werte der Spannungswelligkeit und des Stroms verbunden ist.

9. Vorrichtung nach Anspruch 6, **dadurch gekennzeichnet, dass** das Mittel (5) zur Bestimmung der Stromwelligkeit durch einen Stromtransformator gebildet ist, der ein Abbild des in dem Kondensator fließenden Stroms gibt.

10. Vorrichtung nach Anspruch 6, **dadurch gekennzeichnet, dass** die Vergleichsmittel (12) durch einen Stromkreis gebildet sind, der den Betriebs-Ersatzserienwiderstand (ESR$_f$) mit dem theoretischen Ersatzserienwiderstand (ESR$_t$) vergleicht und mit einem Alarmkreis (13) verbunden ist, der ein Alarmsignal abgibt, wenn der Unterschied zwischen den Werten der Widerstände eine bestimmte Schwelle überschreitet.

11. Vorrichtung, die zum Bestimmen des Alterungszustands eines Kondensators geeignet ist, der mit einem statischen Wandler gemäß einem der Ansprüche 6 bis 10 verbunden ist,

**dadurch gekennzeichnet, dass** sie Bandpassfilter ($7_1$, $7_2$) umfasst, deren mittlere Frequenz an die Pendelfrequenz des statischen Wandlers gebunden ist.

12. Kondensator, **dadurch gekennzeichnet, dass** er mit einer Vorrichtung (1) gemäß einem der Ansprüche 6 bis 10 ausgestattet ist.

FIG.1

FIG.4

ESR,Z

FIG.2

FIG.3